# EUROPEAN PATENT APPLICATION

(11) **EP 2 669 344 A1**
(43) Date of publication of application: **04.12.2013**
(21) Application number: 12739920.2
(22) Date of filing: 24.01.2012
(51) Int. Cl.: C09J 1/00, C09J 9/02, C09J 11/06, H01B 1/22, H01L 21/52

(54) **ADHESIVE COMPOSITION AND SEMICONDUCTOR DEVICE USING SAME**

(30) Priority: 28.01.2011 JP 2011016902
(71) Applicant: Hitachi Chemical Company, Ltd., Chiyoda-ku Tokyo 100-6606 (JP)
(72) Inventor: KONNO Kaoru, Tsukuba-shi Ibaraki 300-4247 (JP); HAYASHI Hiroki, Tsukuba-shi Ibaraki 300-4247 (JP); NATORI Michiko, Tsukuba-shi Ibaraki 300-4247 (JP)
(74) Representative: HOFFMANN EITLE
(86) International application number: PCT/JP2012/051459
(87) International publication number: WO 2012/102275

(57) **Abstract**

The adhesive composition of the present invention includes (A) flake silver particles wherein an oxygen state ratio derived from silver oxide measured by X-ray photoelectron spectroscopy is less than 15% and (B) an alcohol or carboxylic acid having a boiling point of 300°C or more.

## Description

### Technical Field

The present invention relates to an adhesive composition and a semiconductor device using the same. More particularly, it relates to an adhesive composition suitable for bonding semiconductor elements such as power ICs, LSIs, and light emitting diodes (LEDs) to substrates such as lead frames, ceramic wiring boards, glass epoxy wiring boards, and polyimide wiring boards, and to a semiconductor device using the same.

### Background Art

Methods of bonding semiconductor elements and lead frames (supporting members) when producing semiconductor devices include a method of dispersing a filler such as silver powder in a resin such as an epoxy resin and a polyimide resin to form a paste state (for example, silver paste) and using the paste as an adhesive. In this method, the pasty adhesive is applied to a die pad of the lead frame using a dispenser, a printing machine, a stamping machine, or the like. Subsequently, the semiconductor elements are subjected to die bonding and at the time they are bonded by heat-curing the adhesive to produce a semiconductor device.

In recent years, as the higher speed and higher integration of semiconductor elements advance, high heat dissipation characteristics are required in order to ensure the operation stability of semiconductor devices. Further, for the cost reduction of semiconductor parts, the adoption of a lead frame whose surface is made of a base metal (such as Ni plating or Cu) has increased without employing expensive precious metal plating (such as Au or Ag). That is, in order to satisfy the above-mentioned requirements, an adhesive composition which combines high thermal conduction property and high adhesion to the surface of base metals is required.

As a means to achieve heat dissipation properties higher than those of conventional electrically conductive adhesives by the contact of metal particles, there have been proposed a composition highly filled with silver particles of which thermal conductivity is high (Patent Literatures 1 to 3), a composition containing a low melting point solder (Patent Literature 4), a composition using metal nanoparticles which are excellent in sintering properties and the have an average particle size of 0.1 µm or less (Patent Literature 5), an adhesive composition using micro-sized silver particles to which special surface treatment is applied so that the silver particles are sintered to each other by heating at 100°C or more and 400°C or less (Patent Literature 6).

### Citation List

### Patent Literature

Patent Literature 1: Japanese Unexamined Patent Application No. 2006-73 811
Patent Literature 2: Japanese Unexamined Patent Application No. 2006-302834
Patent Literature 3: Japanese Unexamined Patent Application No. 11-66953
Patent Literature 4: Japanese Unexamined Patent Application No. 2005-93996
Patent Literature 5: Japanese Unexamined Patent Application No. 2006-83377
Patent Literature 6: Japanese Patent No. 4353380

### Summary of Invention

### Technical Problem

However, in the conventional method of highly filling silver particles of which thermal conductivity is high, a very large amount of silver particles is required, wherein the filling amount of silver particles is 95 mass% or more, in order to ensure a thermal conductivity of 20 W/m.K or more required in power ICs and LEDs in recent years.

When the filling amount of silver particles increases, it is a problem that stringiness or the like occurs during dispensing because viscosity increases and it becomes impossible to ensure workability. If a solvent is added in a large amount for ensuring workability, a reduction in the adhesive strength due to void generation or a residual solvent will pose a problem.

Further, in the method of using a composition containing a low melting point solder to form a thermal conduction path by metallic bonding and metallization with an adherend, when a package (PKG) such as a power IC and an LED is mounted on a substrate, it is exposed to 260°C in a reflow furnace. There is a problem that, depending on its thermal history, a joined part is remelted and connection reliability is not obtained.

Further, in the method of using metal nanoparticles, although it is possible to avoid the problem of remelting of a joined part, there is concern that a lot of cost is required in order to produce nano-sized metal particles. Further, when the content of nanoparticles in an adhesive composition is low, there is a problem such that the development of high thermal conduction property becomes difficult.

Furthermore, in the method of subjecting silver particles to a specific surface treatment, although sintering is accelerated, and a solid state silver excellent in electrical conduction property and thermal conduction property is obtained, there is a problem that the adhesive strength to the surface of a base metal (such as Ni and Cu) frequently employed in semiconductor mounting components is low.

Thus, the present invention aims to provide an adhesive composition which has high electrical conduction property and thermal conductivity even when joined at a curing temperature of 300°C or less without applying a load and has sufficient adhesive strength to the surface of a base metal even when joined in the atmospheric air, and to provide a semiconductor device using the same.

### Solution to Problem

In view of the above circumstances, the adhesive composition of the present invention comprises (A) flake silver particles wherein an oxygen state ratio derived from silver oxide measured by X-ray photoelectron spectroscopy is less than 15% and (B) an alcohol or carboxylic acid having a boiling point of 300°C or more. Note that the boiling point in the present invention means the boiling point at 1 atm.

It is preferable that the above adhesive composition further comprise (C) a volatile component having the boiling point of 100°C or more and less than 300°C.

It is preferable that the above silver particles be silver particles that have been subjected to treatment of removing the oxide film thereof and surface treatment with a surface protection material.

It is preferable that the silver particles include silver particles in which an average particle size is 0.1 µm or more and 50 µm or less.

It is preferable that a volume resistivity and a thermal conductivity of a cured product prepared by heat-curing the adhesive composition of the present invention be 1 × 10⁻⁴ Ω·cm or less and 30 W/m.K or more, respectively.

It is preferable that the above adhesive composition be cured under conditions of 100 to 300°C for 5 seconds to 10 hours, more preferably 150 to 300°C for 30 minutes to 5 hours, further preferably 200 to 300°C for 1 to 2 hours, particularly preferably at 250°C for 1 hour.

Further, the present invention provides a semiconductor device having a structure wherein a semiconductor element and a supporting member for mounting the semiconductor element are bonded via the above adhesive composition of the present invention.

### Advantageous Effects of Invention

The present invention can provide an adhesive composition which has high electrical conduction property and thermal conductivity even when joined at a curing temperature of 300°C or less without applying a load and has sufficient adhesive strength to a surface of a base metal even when joined in the atmospheric air, and can provide a semiconductor device using the same. Such an adhesive composition is suitably used as an electrically conductive connection material, an electrically conductive adhesive, or a die bonding material.

### Brief Description of Drawings

Figure 1 is a schematic diagram of silver particles in which silver particles with small oxide film on the surface have been subjected to surface treatment with a surface protection material.
Figure 2 is a schematic diagram showing a state in which the surface protection material of the silver particles shown in Figure 1 is desorbed, and the silver particles are sintered to each other.
Figure 3 is a schematic diagram of silver particles in which silver particles with large oxide film on the surface have been subjected to surface treatment with a surface protection material.
Figure 4 is a schematic diagram showing a state in which although the surface protection material of the silver particles shown in Figure 3 is desorbed, the silver particles cannot be sintered to each other.
Figure 5 is a schematic diagram of silver particles in which silver particles with large oxide film have been subjected to treatment of removing the surface oxide film and surface treatment with a surface protection material.
Figure 6 is a schematic diagram showing a state in which the surface protection material of the silver particles shown in Figure 5 is desorbed, and the silver particles are sintered to each other.
Figure 7 is a schematic cross section showing an example of the semiconductor device according to the present embodiment.
Figure 8 is a schematic cross section showing another example of the semiconductor device according to the present embodiment.

### Description of Embodiments

Hereinafter, suitable embodiments of the present invention will be described in detail referring to drawings.

The adhesive composition of the present embodiment comprises (A) flake silver particles in which an oxygen state ratio derived from silver oxide measured by X-ray photoelectron spectroscopy is less than 15% (hereinafter also referred to as "component (A)") and (B) an alcohol or carboxylic acid having a boiling point of 300°C or more (hereinafter also referred to as "component (B)") as essential components. Hereinafter, each component will be described in detail.

### (Component (A))

In the silver particles used for the adhesive composition of the present embodiment, the oxygen state ratio derived from silver oxide is less than 15%. If the oxygen state ratio derived from silver oxide is 15% or more, the sintering of silver particles to each other will be prevented while the oxide film remain widely covering the surface of the silver particles at a temperature of 300°C or less or in the environment without a reducing agent promoting the removal of oxide film, and the path of metallic bonding of the silver particles to each other will not be sufficiently formed, and therefore, the thermal conductivity of the adhesive composition using the silver particles will be reduced. Note that, it is preferable that the oxygen state ratio derived from silver oxide be less than 10%, and it is more preferably less than 5% for more densely forming the path of metallic bonding among silver particles to each other or between the silver particles and an adherend in order to achieve high adhesive strength.

The amount of oxide films on the surface of silver particles is based on the state ratio calculated from the data measured by X-ray photoelectron spectroscopy. An S-Probe ESCA Model 2803 of Surface Science Instrument Company was used as the analyzer for the X-ray photoelectron spectroscopy, and the Al Kα-ray was used for the X-ray for irradiation. The oxygen derived from silver oxide film was defined as the component having a peak at 531 ± 1 eV, which was distinguished from the oxygen derived from other components such as a surface protection material. The "state ratio" means the concentration of a specific element in a measuring sample and is shown as a value calculated from the strength of the element using a relative sensitivity coefficient attached to apparatus.

Further, the silver particles used in the adhesive composition of the present embodiment include particles in which the shape is flake. The shape of silver particles is a shape when analyzed from scanning electron microscope (SEM) observation, and philips XL30 can be used as the observation apparatus of SEM. In the present embodiment, analysis is performed from the results of SEM observation, and a shape in which the average thickness t is in the range of 0.1 µm to 15 µm and the aspect ratio (average particle size a/average thickness t) is in the range of 2 to 1000 is defined as flake. The average particle size a as described here is defined as the average value of the square root of the area S determined in a planar view of five flake silver particles which have been selected at random.

Examples of the flake particles include particles with a shape called tabular, dished, scaly, and flaky. When flake silver particles are brought into contact with each other, the contact area increases compared with the case where granular silver particles are brought into contact with each other. Therefore, if the adhesive composition containing flake silver particles is heat-cured, the denseness of sintering of silver particles to each other will increase, and as a result, presumably, not only the thermal conductivity and the electrical conductivity of a cured product of the adhesive composition, but also adhesive strength to the surface of a base metal is improved.

Further, the average particle size of spherical silver particles refers to a particle size at a cumulative value (by volume) of 50% in the particle size distribution obtained by a laser diffraction and scattering particle size distribution measuring method. The average particle size of spherical silver particles is preferably 0.1 µm or more and 50 µm or less. An average particle size of 0.1 µm or more is preferred when the production cost of particles is taken into consideration, and an average particle size of 50 µm or less is preferred when the filling factor of particles is taken into consideration in order to improve the thermal conductivity.

The proportion of the above silver particles in the adhesive composition is preferably 80 parts by mass or more in 100 parts by mass of the adhesive composition in order to improve the thermal conductivity, and is more preferably 87 parts by mass or more in order to achieve the thermal conductivity equal to or higher than that of high temperature solder. Further, the proportion of silver particles is preferably 99 parts by mass or less in order to make the adhesive composition pasty, and is more preferably 95 parts by mass or less in order to improve the workability in a dispenser or a printing machine.

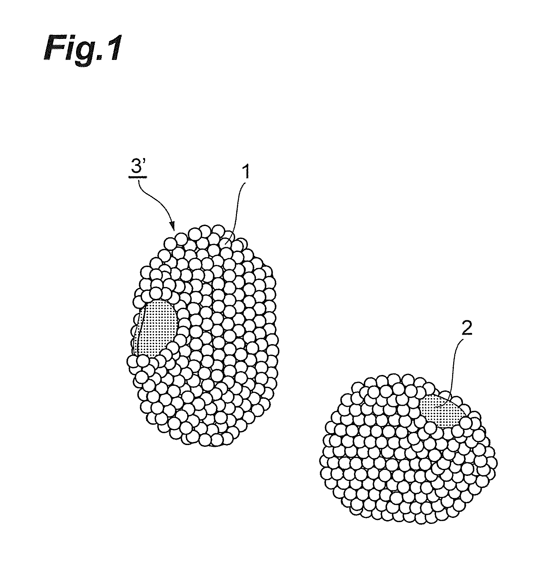

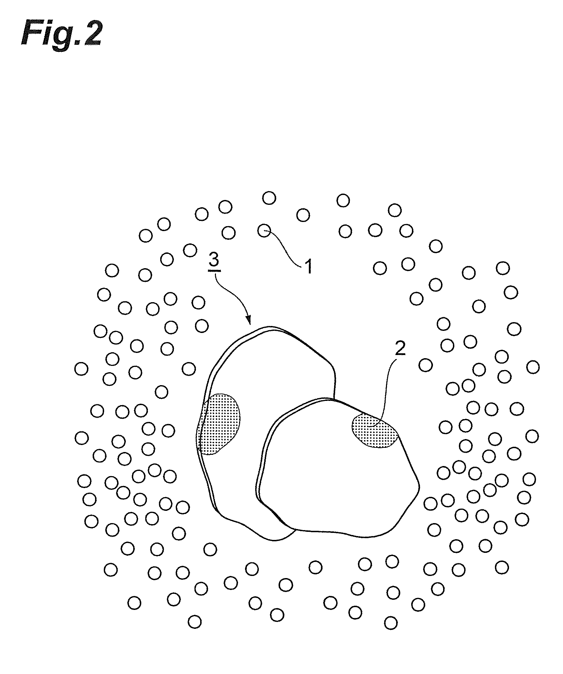

Although the reason why the above effect is obtained by using such silver particles is not necessarily obvious, the discussions of the present inventors will be described based on the schematic diagrams of Figures 1 and 2.

First, when flake silver particles with small oxide film on the surface are subjected to surface treatment with a surface protection material, the silver particles are presumably in a state as shown in Figure 1. That is, the silver particles are presumably in a state (3') where a slightly remaining oxide film 2 is present on a flake silver particle 3, and a surface protection material 1 presumably covers the silver particle 3 in a manner to avoid the oxide film 2.

In this case, the surface protection material 1 is desorbed by heating at 300°C or less, and the active surface of the silver particle 3 is exposed, as shown in Figure 2. When this active surface is brought into contact with the active surface of other silver particles, sintering is accelerated, and the path of metallic bonding between silver particles to each other is formed. Further, since each silver particle 3 is flake, the contact area when the silver particles are brought into contact with each other is large. The present inventors guess that, owing to the above subjects, the adhesive composition containing silver particles has high thermal conductivity and high electrical conductivity, and its adhesive strength to the surface of a base metal is improved even when it is heated and cured at 300°C or less.

The silver particles are preferably silver particles which have been subjected to treatment of removing the oxide film thereof and surface treatment with a surface protection material. This can prevent reoxidation and the aggregation of silver particles. The treatment of removing the oxide films and the surface treatment with a surface protection material can be performed, for example, by the methods as shown below.

First, silver particles are added to an acidic solution in which a surface protection material is dissolved, dispersed, and surface protection is performed while removing oxide films with stirring. At this time, the amount of addition of the silver particles is preferably 1 to 50 parts by mass relative to 100 parts by mass of the acidic solution.

Next, after retrieving the silver particles by filtering the solution, the surface protection material and the acid component which have physically adsorbed to the surface of the silver particles are washed with a solvent. Subsequently, an excess solvent is removed by subjecting the silver particles to reduced pressure drying to obtain silver particles which are in a dry state and surface-treated.

Note that in the process of the oxide film removal, when the oxide film treatment is performed in an acidic solution which does not contain a surface protection material, silver particles may aggregate to each other, and powder-form silver particles having an average particle size equivalent to that of the particles before the oxide film treatment may not be obtained. In order to prevent the aggregation of silver particles, it is preferable to add a surface protection material to an acidic solution to perform oxide film removal and surface treatment at the same time.

Although the acidic solution is not limited, sulfuric acid, nitric acid, hydrochloric acid, acetic acid, phosphoric acid, and the like can be used as an acid. Although a diluent solvent of an acid is also not limited, a solvent in which the compatibility with an acid is good and which is excellent in the solubility, dispersibility of a surface protection material is preferred.

The concentration of the acid in the acidic solution, when the whole acidic solution is 100 parts by mass, is preferably 1 part by mass or more in order to remove the oxide film, and more preferably 5 parts by mass or more when the solution contains silver particles with thick oxide film.

Further, it is preferably 50 parts by mass or less because metal will be dissolved in the solution in a large amount if the concentration of an acid is too high, and it is preferably 40 parts by mass or less in order to prevent the aggregation of particles to each other.

The surface protection material is preferably a compound having a terminal functional group in which the adsorption on the surface of silver particles is good. Specific examples thereof include compounds having a hydroxyl group, a carboxyl group, an amino group, a thiol group, and a disulfide group. Further, in order to more highly prevent the reoxidation of silver particles and the adsorption and contamination of excess organic matter, the main skeleton of the compound is preferably that having a linear alkane skeleton in which the surface protection material may be densely filled.

It is more preferable that the linear alkane skeleton have four or more carbon atoms. The surface protection material having such a linear alkane skeleton is more densely filled by the intermolecular force of carbon chains to each other.

Further, it is more preferable that the linear alkane skeleton have 18 or more carbon atoms. The surface protection material having such a linear alkane skeleton can sinter silver particles at a low temperature of 300°C or less because the desorption temperature of the surface protection material from the metal surface is lower than 300°C.

The concentration of the surface protection material in the acidic solution, when the whole acidic solution is 100 parts by mass, is preferably 0.0001 part by mass or more in order to prevent the aggregation of silver particles to each other, and is preferably 0.1 part by mass or less in order to prevent excessive physical adsorption of the surface protection material on the silver particles.

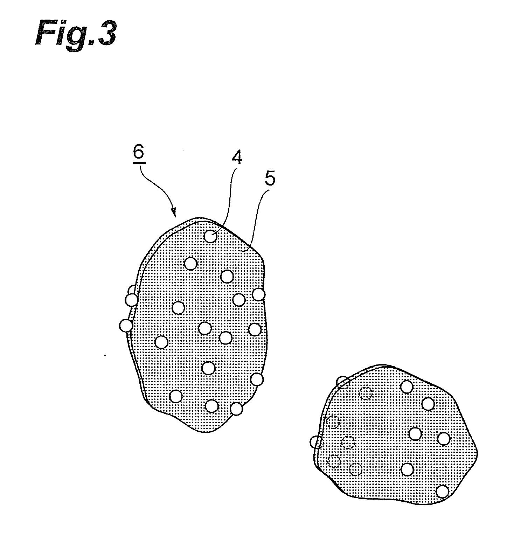

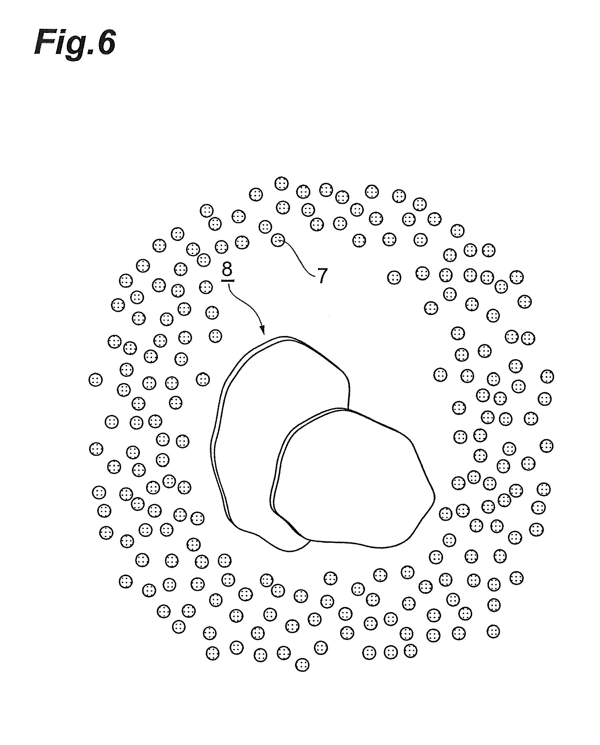

Here, the discussions of the present inventors on the reason why the effect of the present embodiment is obtained even when using silver particles with large oxide film will be described based on the schematic diagrams of Figures 3 to 6.

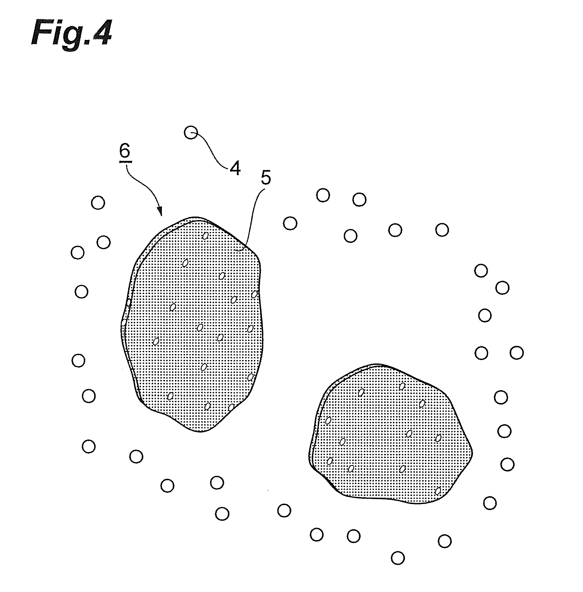

In the case of silver particles 6 with large oxide film 5 as shown in Figure 3, if it is heated at 300°C or less, a surface protection material 4 is presumably desorbed as shown in Figure 4, but since the surface of silver particles 6 is widely covered with an oxide film 5, the sintering of the silver particles 6 to each other presumably not easily occurs.

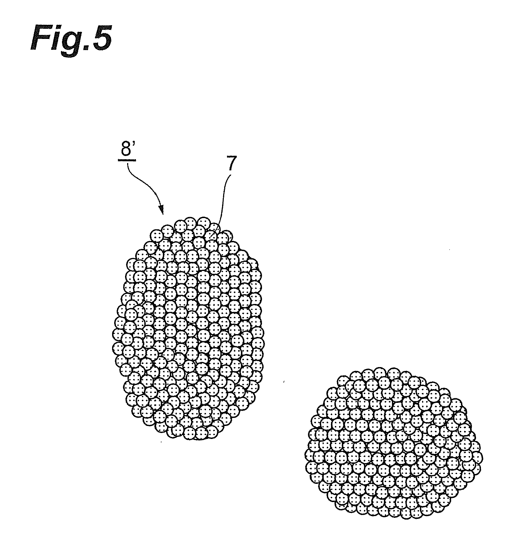

On the other hand, even when using silver particles with large oxide film, when the silver particles are subjected to treatment of removing the oxide film 5 on the surface and surface treatment with a surface protection material, a silver particle 8' in a state where the oxide film 5 is not present and the whole surface is covered with a surface protection material 7 is obtained as shown in Figure 5.

In this case, similar to the silver particle 3 as shown in Figure 1, the surface protection material 7 is desorbed by heating at 300°C or less, and the active surface of the silver particle 8 is exposed. When this active surface is brought into contact with the active surface of other silver particles, sintering is accelerated, and the path of metallic bonding between silver particles is formed. In this case, since the exposed area of the active surface of the silver particle 8 is larger than that of the silver particles of Figure 1, the sintering is presumably more accelerated, and higher thermal conductivity is presumably obtained.

### (Component (B))

The alcohol or carboxylic acid having a boiling point of 300°C or more is not particularly limited as long as it does not disturb the sintering of silver particles.

Examples of the component (B) include aliphatic carboxylic acids such as palmitic acid, stearic acid, arachidic acid, terephthalic acid, and oleic acid, aromatic carboxylic acids such as pyromellitic acid and o-phenoxybenzoic acid, aliphatic alcohols such as cetyl alcohol, isobornyl cyclohexanol, and tetraethylene glycol, and aromatic alcohols such as p-phenylphenol. Among these, it is preferable that the melting points of these alcohols or carboxylic acids be lower than the temperature when applying a thermal history. This is because, during the heating, the wettability of a liquid with an adherend and silver particles is improved and the reactivity is enhanced compared with a solid, thereby capable of improving the adhesive strength to the adherend. Among these, aliphatic alcohols or carboxylic acids having 6 to 20 carbon atoms are particularly preferred. The adhesive composition containing these carboxylic acids or alcohols not only is good in sintering properties of silver particles, but is excellent in the coating workability of the adhesive composition in a dispenser or a printing machine due to the improvement in dispersibility of silver particles and the prevention thereof from settling.

The component (B) may be used alone or as a mixture of two or more compounds as necessary. When the total amount of the adhesive composition is 100 parts by mass, the component (B) is preferably 0.1 part by mass to 20 parts by mass. If the component (B) is more than 20 parts by mass, the electrical conduction property, thermal conduction property, or adhesive strength to the surface of a base metal may be impaired because when a predetermined thermal history is applied, a residual component (B) may prevent the aggregation or sintering of silver particles, and the denseness of sintering between silver particles may be impaired; and if the component (B) is less than 0.1 part by mass, an accelerating effect on the sintering of silver particles may not sufficiently be obtained, and the adhesive strength may be reduced.

### (Component (C))

The adhesive composition of the present embodiment may further comprise a volatile component (C) (hereinafter also referred to as "component (C)" optionally). The volatile component is not particularly limited as long as it has a boiling point of 100°C or more and less than 300°C, and silver particles undergo sintering when a predetermined thermal history is applied to a mixture thereof with the silver particles.

Examples of such volatile components include mono- and poly-hydric alcohols such as pentanol, hexanol, heptanol, octanol, decanol, ethylene glycol, diethylene glycol, propylene glycol, butylene glycol, and α-terpineol; ethers such as ethylene glycol butyl ether, ethylene glycol phenyl ether, diethylene glycol methyl ether, diethylene glycol ethyl ether, diethylene glycol butyl ether, diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether; esters such as ethylene glycol ethyl ether acetate, ethylene glycol butyl ether acetate, diethylene glycol ethyl ether acetate, diethylene glycol butyl ether acetate, dipropylene glycol methyl ether acetate, ethyl lactate, butyl lactate, and γ-butyrolactone; acid amides such as N-methyl-2-pyrrolidone, N,N-dimethylacetamide, and N,N-dimethylformamide; aliphatic hydrocarbons such as cyclohexanone, octane, nonane, decane, and undecane; aromatic hydrocarbons such as benzene, toluene, and xylene; and suitable mercaptans such as mercaptans containing 1 to 18 carbon atoms, for example, ethyl, n-propyl, i-propyl, n-butyl, i-butyl, t-butyl, pentyl, hexyl, and dodecyl mercaptan, or cycloalkyl mercaptans such as mercaptans containing 5 to 7 carbon atoms such as cyclopentyl, cyclohexyl, or cycloheptyl mercaptan. Among these, a volatile component of which boiling point is 150°C or more is preferred. It is because the adhesive composition comprising a volatile component of which boiling point is 150°C or more shows a very small increase in viscosity during mounting work and is excellent in stability of coating work such as dispensing during the preparation of semiconductor devices. Among these, alcohols, esters, and ethers having 4 to 12 carbon atoms are particularly preferred. It is because these volatile components are excellent in the dispersibility of silver particles which have been subjected to oxide film removal and surface treatment, and there is little concern of clogging during dispensing due to the settling of silver particles or the like.

The volatile component may be used alone or as a mixture of two or more components as necessary, and it is preferable that the amount of the volatile component is 20 parts by mass or less in 100 parts by mass of the adhesive composition for the improvement of thermal conduction property.

The adhesive composition of the present embodiment may also comprise one or more of a diluent for improving workability, a wettability improver, and a defoaming agent. Note that the adhesive composition of the present embodiment may comprise components other than those listed here.

Further, it is possible to suitably add moisture absorbents such as calcium oxide and magnesium oxide, adhesive strength improvers such as a silane coupling agent, a titanate coupling agent, an aluminum coupling agent, and a zircoaluminate coupling agent, wetting improvers such as a nonionic surfactant and a fluorine-based surfactant, defoaming agents such as silicone oil, ion-trapping agents such as an inorganic ion exchanger, polymerization inhibitors, and the like to the adhesive composition of the present embodiment as necessary.

Here, examples of the silane coupling agents include vinyltris(β-methoxyethoxy)silane, vinyltriethoxysilane, vinyltrimethoxysilane, γ-methacryloxypropyltrimethoxysilane, β-(3,4-epoxycyclohexyl)ethyltrimethoxysilane, γ-glycidoxypropyltrimethoxysilane, γ-glycidoxypropylmethyldiethoxysilane, N-phenyl-γ-aminopropyltrimethoxysilane, γ-mercaptopropyltrimethoxysilane, hexamethyldisilazane, N,O-(bistrimethylsilyl)acetamide, N-methyl-3-aminopropyltrimethoxysilane, 4,5-dihydroimidazolepropyltriethoxysilane, γ-mercaptopropyltriethoxysilane, γ-mercaptopropylmethyldimethoxysilane, 3-cyanopropyltrimethoxysilane, methyltri(methacryloyloxyethoxy)silane, methyltri(glycidyloxy)silane, 2-ethylhexyl-2-ethylhexylphosphonate, γ-glycidoxypropylmethyldimethoxysilane, vinyltriacetoxysilane, γ-anilinopropyltrimethoxysilane, γ-mercaptopropylmethyldimethoxysilane, γ-methacryloxypropylmethyldimethoxysilane, N-trimethylsilylacetamide, dimethyltrimethylsilylamine, diethyltrimethylsilylamine, trimethylsilylimidazole, trimethylsilylisocyanate, dimethylsilyldiisocyanate, methylsilyltriisocyanate, vinylsilyltriisocyanate, phenylsilyltriisocyanate, tetraisocyanatesilane, and ethoxysilanetriisocyanate.

Examples of the above titanate coupling agents include isopropyltriisostearoyl titanate, isopropyltrioctanoyl titanate, isopropyldimethacrylisostearoyl titanate, isopropyltridodecylbenzenesulphonyl titanate, isopropylisostearoyldiacryl titanate, isopropyltri(dioctylphosphate)titanate, isopropyltricumylphenyl titanate, isopropyltris(dioctylpyrophosphate)titanate, tetraisopropylbis(dioctylphosphite)titanate, tetraoctylbis(ditridecylphosphite)titanate, tetra(2,2-diallyloxymethyl-1-butyl)bis(ditridecyl)phosphite titanate, dicumylphenyloxyacetate titanate, bis(dioctylpyrophosphate)oxyacetate titanate, diisostearoylethylene titanate, bis(dioctylpyrophosphate)ethylene titanate, diisopropoxy-bis(2,4-pentadionate)titanium (IV), diisopropylbistriethanolamino titanate, titanium lactate, acetoacetic ester titanate, di-i-propoxybis(acetylacetonato)titanium, di-n-butoxybis(triethanolaminato)titanium, dihydroxybis(lactato)titanium, titanium-i-propoxyoctylene glycolate, titanium stearate, tri-n-butoxytitanium monostearate, titanium lactate ethyl ester, and titanium triethanolaminate.

A bleeding inhibitor can be further added to the adhesive composition of the present embodiment as necessary. Examples of the bleeding inhibitor include fatty acid such as perfluorooctanoic acid, octanamide, and oleic acid, perfluorooctylethyl acrylate, and silicone.

For producing the above adhesive composition, the component (A) and the component (B), together with the component (C) and the like to be added as necessary, may be collectively or dividedly mixed, dissolved, disintegrated and kneaded, or dispersed with heating as necessary using an appropriate combination of dispersing/dissolving apparatuses such as a stirrer, a mortar and pestle machine, a triple roll mill, or a planetary mixer to form a homogeneous paste.

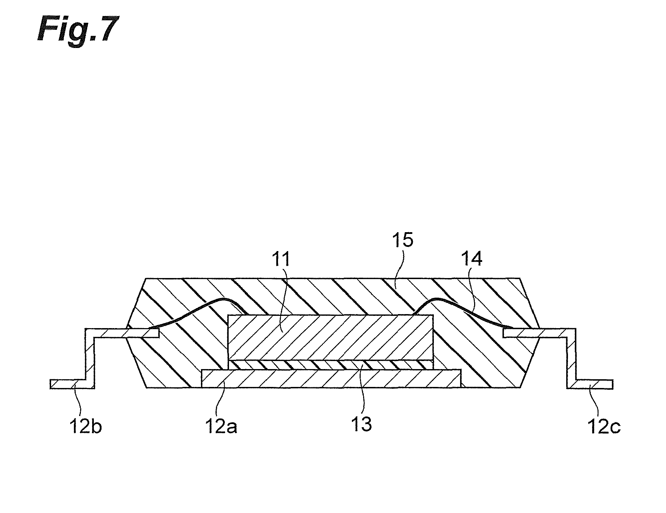

Figure 7 is a schematic cross section showing an example of the semiconductor devices produced using the adhesive composition of the present embodiment. The semiconductor device shown in Figure 7 comprises three lead frames (radiators) 12a, 12b, and 12c, a chip (heating element) 11 connected onto the lead frame 12a through the adhesive composition 13 of the present embodiment, and a mold resin 15 for molding them. The chip 11 is connected to lead frames 12b and 12c through two wires 14, respectively.

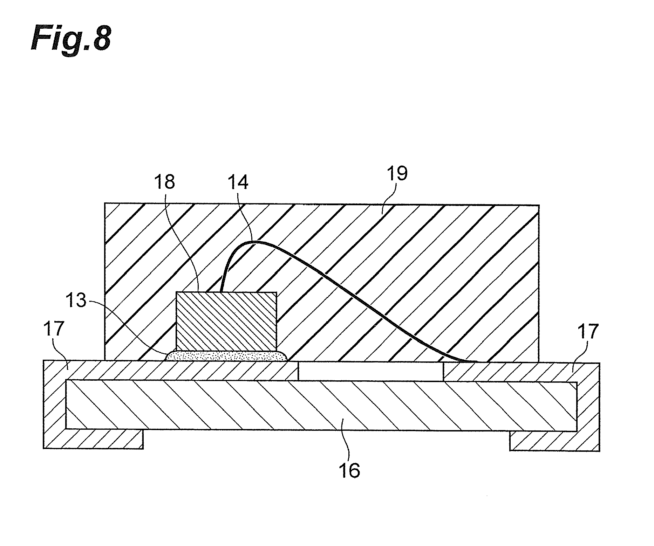

Figure 8 is a schematic cross section showing another example of the semiconductor devices produced using the adhesive composition of the present embodiment. The semiconductor device shown in Figure 8 comprises a substrate 16, two lead frames 17 formed so as to surround the substrate 16, an LED chip 18 connected onto the lead frames 17 through the adhesive composition 13 of the present embodiment, and a translucent resin 19 for sealing them. The LED chip 18 is connected to the lead frames 17 through a wire 14.

The semiconductor device of the present embodiment is obtained by bonding a semiconductor element to a supporting member using the adhesive composition of the present embodiment. After bonding the semiconductor element to the supporting member, a wire bonding step and a sealing step are performed as necessary.

Examples of the supporting member include lead frames such as a 42 alloy lead frame, a copper lead frame, and a palladium PPF lead frame and organic substrates such as a glass epoxy substrate (a substrate comprising a glass fiber-reinforced epoxy resin) and a BT substrate (a substrate employing a BT resin comprising a cyanate monomer or an oligomer thereof and bismaleimide).

For bonding a semiconductor element to a supporting member such as a lead frame using the adhesive composition of the present embodiment, can be first coated on the supporting member by a dispensing method, a screen printing method, a stamping method or the like, and thereafter the semiconductor element can be mounted thereon and then the adhesive composition can be heat cured using a heating apparatus such as an oven or a heat block. The heat curing is usually performed by heating at 100 to 300°C for 5 seconds to 10 hours. A subsequent wire bonding step followed by sealing by a common method can produce a finished semiconductor device.

### Examples

Hereinafter, the present invention will be described in detail with reference to Examples, but the present invention is not limited by Examples. The materials used in Examples and Reference Examples are prepared or obtained as follows.

(1) Alcohol or carboxylic acid having a boiling point of 300°C or more: stearic acid (boiling point; 376°C, Wako Pure Chemical Industries, Ltd.), palmitic acid (boiling point; 390°C, Wako Pure Chemical Industries, Ltd.), isobornyl cyclohexanol (boiling point; 308°C, hereinafter abbreviated as MTPH)

(2) Volatile component: dipropylene glycol dimethyl ether (boiling point; 175°C, hereinafter abbreviated as DMM, Daicel Chemical Industries Ltd.), γ-butyrolactone (boiling point; 204°C, hereinafter abbreviated as GBL, Sankyo Chemical Co., Ltd.), triethylene glycol butyl methyl ether (boiling point; 261°C, hereinafter abbreviated as BTM, TOHO Chemical Industry Co., Ltd.), and diethylene glycol monobutyl ether (boiling point; 231°C, hereinafter abbreviated as BDG, Daicel Chemical Industries Ltd.)

(3) Silver particles: AgF10S (Tokuriki Chemical Research Co., Ltd., trade name, silver powder, average particle size: 10 µm, spherical, oxygen state ratio: 15%), AgC-212D (Fukuda Metal Foil & Powder Co., Ltd., trade name, silver powder, average particle size: 3.1 µm, flake, oxygen state ratio: 5%)

### (4) Surface-treated silver particles:

### (i) Surface-treated spherical silver powder

Hydrochloric acid (Kanto Chemical Co., Inc.) in an amount of 28 parts by mass was diluted with ethanol (Kanto Chemical Co., Inc.) to prepare 80 parts by mass of an acidic solution. To this acidic solution, 0.29 part by mass of stearyl mercaptan (Tokyo Chemical Industry Co., Ltd.) was added as a surface protection material to prepare a surface treatment liquid. To the surface treatment liquid, 20 parts by mass of the above AgF10S was added, and the resulting mixture was stirred for 1 hour while maintaining the mixture at 40°C to thereby perform the oxide film removal and surface treatment. Subsequently, the surface treatment liquid was removed by filtration, and the surface-treated silver powder was washed by adding ethanol at 40°C. Further, the ethanol washing solution was removed by filtration, and the steps of washing and filtration were repeated about 10 times to thereby remove the stearyl mercaptan and hydrochloric acid physically adsorbed on the surface of the surface-treated silver powder. The surface-treated silver powder after washing was finally dried under reduced pressure to thereby remove ethanol to obtain a surface-treated silver powder in a dry state. The oxygen state ratio of the obtained surface-treated silver powder was 0%, and it was verified that the oxide film was removed.

### (ii) Surface-treated flake silver powder

Hydrochloric acid (Kanto Chemical Co., Inc.) in an amount of 4 parts by mass was diluted with ethanol (Kanto Chemical Co., Inc.) to prepare 80 parts by mass of an acidic solution. To this acidic solution, 0.28 part by mass of stearic acid (Wako Pure Chemical Industries, Ltd.) was added as a surface protection material to prepare a surface treatment liquid. To the surface treatment liquid, 20 parts by mass of the above AgC-212D was added, and the resulting mixture was stirred for 1 hour while maintaining the mixture at 40°C to thereby perform the oxide film removal and surface treatment. Subsequently, the surface treatment liquid was removed by filtration, and the surface-treated silver powder was washed by adding ethanol at 40°C. Further, the ethanol washing solution was removed by filtration, and the steps of washing and filtration were repeated about 10 times to thereby remove the stearic acid and hydrochloric acid physically adsorbed on the surface of the surface-treated silver powder. The surface-treated silver powder after washing was finally dried under reduced pressure to thereby remove ethanol to obtain a surface-treated silver powder in a dry state. The oxygen state ratio of the obtained surface-treated silver powder was 1%, and it was verified that the oxide film was removed.

### (Examples 1 to 7 and Reference Examples 1 to 6)

The materials (1) and (2) in a blending ratio as shown in Table 1 or 2 were kneaded in a mortar and pestle machine for 10 minutes to obtain a liquid component. Further, surface-treated or untreated silver particles (3) or (4) were added to the liquid component, and the resulting mixture was kneaded in a mortar and pestle machine for 15 minutes to obtain an adhesive composition.
The properties of the adhesive compositions were investigated by the methods as shown below, and the results of the measurements are shown in Tables 1 and 2.

Die shear strength: An adhesive composition in an amount of about 0.2 mg was applied on a Ag-plated Cu lead frame (land portion: 10 × 5 mm), a 2 mm × 2 mm Ni-plated Cu chip (Ni plating thickness; 1 µm, chip thickness; 150 µm) was bonded thereto, and this was heat-treated in a clean oven (PVHC-210, manufactured by TABAI ESPEC CORP.) at 250°C for 1 hour. This was measured for the shear strength (MPa) using a Multipurpose Bondtester (4000 series, manufactured by Dage, Ltd.) at a measurement speed of 500 µm/s and a measuring height of 100 µm.

Thermal conductivity of cured product of adhesive composition: The above adhesive composition was heat-treated in a clean oven (PVHC-210, manufactured by TABAI ESPEC CORP.) at 250°C for 1 hour to obtain a test piece with a size of 10 × 10 × 1 mm. The thermal diffusivity of the test piece was measured by the laser flash method (LFA 447, manufactured by Netzsch, 25°C), and the thermal conductivity (W/m·K) of the cured product of the adhesive composition at 25°C was calculated from this thermal diffusivity and the product of the specific heat capacity obtained with a differential scanning calorimeter (Pyris1 manufactured by PerkinElmer Co., Ltd.) and the specific gravity obtained by an Archimedean method.

Volume resistivity: The above adhesive composition was heat-treated in a clean oven (PVHC-210, manufactured by TABAI ESPEC CORP.) at 250°C for 1 hour to obtain a test piece with a size of 1 × 50 × 0.03 mm on a glass plate. This test piece was measured for the value of volume resistivity at 25°C by a four-terminal method (R687E DIGITAL MULTIMETER, manufactured by ADVANTEST CORP.).

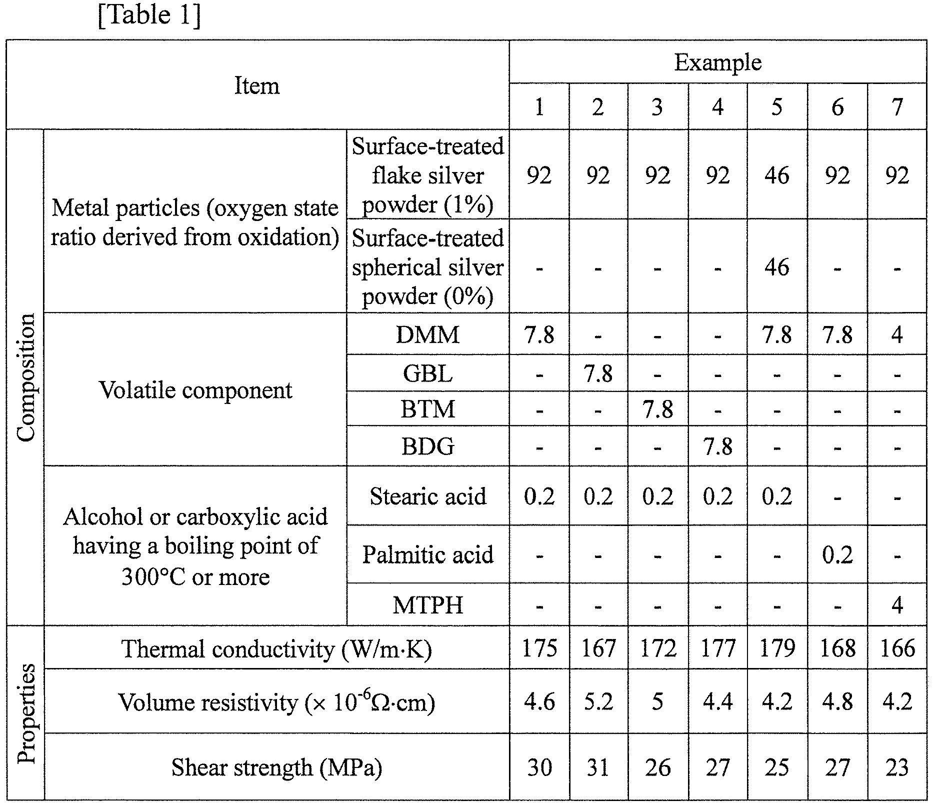

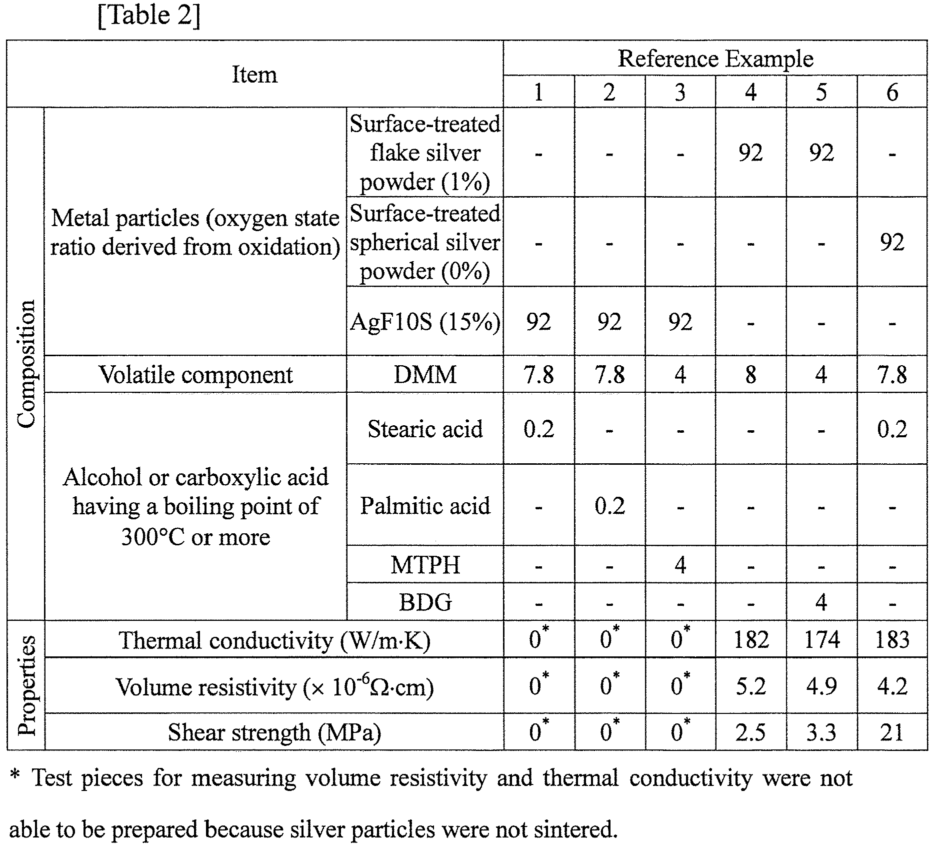

As shown in Tables 1 and 2, Examples 1 to 4 show that a volume resistivity of 5.2 × 10⁻⁶ Ω·cm or less, a high thermal conductivity of 167 W/m.K or more, and a high shear strength of 26 MPa or more have been achieved by heat-treating, at 250°C for 1 hour, a composition comprising a flake silver powder (surface-treated flake silver powder) in which the oxygen state ratio is less than 15%, a volatile component, and an alcohol or carboxylic acid having a boiling point of 300°C or more.

Example 5 shows that a volume resistivity of 4.2 × 10⁻⁶ Ω·cm, a high thermal conductivity of 179 W/m.K, and a high shear strength of 25 MPa have been achieved by heat-treating, at 250°C for 1 hour, a composition comprising a flake silver powder (surface-treated flake silver powder) in which the oxygen state ratio is less than 15% and a spherical silver powder (surface-treated spherical silver powder) in which the oxygen state ratio is less than 15%, a volatile component, and an alcohol or carboxylic acid having a boiling point of 300°C or more.

Examples 6 and 7 show that a volume resistivity of 4.8 × 10⁻⁶ Ω·cm or less, a high thermal conductivity of 166 W/m.K or more, and a high shear strength of 23 MPa or more have been achieved by heat-treating, at 250°C for 1 hour, a composition comprising a flake silver powder (surface-treated flake silver powder) in which the oxygen state ratio is less than 15%, a volatile component, and an alcohol or carboxylic acid having a boiling point of 300°C or more.
The results as described above show that adhesive compositions as described in Examples have higher electrical conduction property, higher thermal conduction property (30 W/m.K), and a higher bonding strength than Sn95Pb solder.

Reference Examples 1 to 3 show that since the sintering of silver particles to each other does not occur at 250°C, test pieces for measuring volume resistivity and thermal conductivity are not able to be prepared from a composition comprising a silver powder (AgF10S) in which the oxygen state ratio is 15%, a volatile component, and an alcohol or carboxylic acid having a boiling point of 300°C or more, and the composition is not connected with an adherend.

Reference Example 4 shows that a composition comprising a flake silver powder (surface-treated flake silver powder) in which the oxygen state ratio is less than 15% and a volatile component develops a volume resistivity of 5.2 × 10⁻⁶ Ω·cm and a high thermal conductivity of 182 W/m.K by the heat treatment at 250°C for 1 hour, but the adhesive strength of an adherend with a Ni-plated part is very weak, the shear strength is 2.5 MPa, and the adhesive strength is inferior to that of Sn95Pb solder.

Reference Example 5 shows that a composition comprising a flake silver powder (surface-treated flake silver powder) in which the oxygen state ratio is less than 15%, a volatile component, and an alcohol (BDG) having a boiling point of less than 300°C develops a volume resistivity of 4.9 × 10⁻⁶ Ω·cm and a high thermal conductivity of 174 W/m.K by the heat treatment at 250°C for 1 hour, but the adhesive strength of an adherend with a Ni-plated part is very weak, the shear strength is 3.3 MPa, and the adhesive strength is inferior to that of Sn95Pb solder. It is assumed that since the timing of volatilization of BDG is too early when a predetermined thermal history was applied, the oxide film or organic coating on the Ni surface was not removed, and it was not able to form a strong bonding phase between the silver particles and the Ni surface, thereby reducing the shear strength.

Reference Example 6 shows that a composition comprising a spherical silver powder (surface-treated spherical silver powder) in which the oxygen state ratio is less than 15%, a volatile component, and an alcohol or a carboxylic acid (stearic acid) having a boiling point of more than 300°C develops a volume resistivity of 4.2 × 10⁻⁶ Ω·cm and a high thermal conductivity of 183 W/m.K by the heat treatment at 250°C for 1 hour, but the adhesive strength of an adherend with a Ni-plated part is very weak, the shear strength is 12 MPa, and the adhesive strength is inferior to that of the adhesive compositions described in Examples 1 to 7. This is estimated that since the shape of the silver particles is spherical, the contact area between the silver particles or between the silver particles and the Ni surface is smaller than the flake silver particles, thereby reducing the shear strength.

### Reference Signs List

1, 4, 7...Surface protection material; 2, 5...Oxide film; 3, 6, 8...Silver particles; 3', 8'...Silver particles covered with surface protection material; 11...Chip; 12a, 12b, 12c...Lead frame; 13...Adhesive composition; 14...Wire; 15...Mold resin; 16...Substrate; 17...Lead frame; 18...Chip; and 19...Translucent resin.

## Claims

1. An adhesive composition comprising:
(A) flake silver particles wherein an oxygen state ratio derived from silver oxide measured by X-ray photoelectron spectroscopy is less than 15%; and
(B) an alcohol or carboxylic acid having a boiling point of 300°C or more.

2. The adhesive composition according to claim 1, further comprising (C) a volatile component having a boiling point of 100°C or more and less than 300°C.

3. The adhesive composition according to claim 1 or 2, wherein the silver particles are silver particles that have been subjected to treatment of removing the oxide film thereof and surface treatment with a surface protection material.

4. The adhesive composition according to any one of claims 1 to 3, wherein the silver particles include silver particles of which an average particle size is 0.1 µm or more and 50 µm or less.

5. The adhesive composition according to any one of claims 1 to 4, wherein volume resistivity and thermal conductivity of a cured product formed by heat-curing the adhesive composition are 1 × 10⁻⁴ Ω·cm or less and 30 W/m.K or more, respectively.

6. A semiconductor device having a structure wherein a semiconductor element and a supporting member for mounting a semiconductor element are bonded via the adhesive composition according to any one of claims 1 to 5.
